# EUROPEAN PATENT APPLICATION

(11) **EP 1 387 405 A2**
(43) Date of publication of application: **04.02.2004**
(21) Application number: 03102384.9
(22) Date of filing: 31.07.2003
(51) Int. Cl.: H01L 27/115, H01L 21/8246

(54) **Semiconductor memory device and method for manufacturing the same**

(30) Priority: 02.08.2002 JP 2002226151
(71) Applicant: NEC Electronics Corporation, Kawasaki, Kanagawa 211-8668 (JP)
(72) Inventor: Mori, Hidemitsu NEC Electronics Corporation, Kawasaki, Kanagawa, 211-8668 (JP)
(74) Representative: Poulin, Gérard

(57) **Abstract**

A semiconductor memory device comprises : an etch stop layer formed on an interconnect stack; a contact stud penetrating the etch stop layer and provided in the interconnect stack of a memory cell to make electrical connection to a diffusion layer of the memory cell transistor; a contact stud penetrating the etch stop layer and provided in the interconnect stack of a plate transistor to make electrical connection to a diffusion layer of the plate transistor; a ferro-electric capacitor formed on the contact stud of the memory cell transistor; an interlayer insulation film formed to cover an upper electrode of the ferro-electric capacitor and the contact stud of the plate transistor; and a plate line providing an electrical connection between the upper electrode of the ferro-electric capacitor and the contact stud of the plate transistor through contact holes formed in the interlayer insulation film.

## Description

### BACKGROUND OF THE INVENTION

### 1. Field of the Invention

The present invention relates to a semiconductor memory device and a method for manufacturing the same, and more particularly to a semiconductor memory device incorporating therein a ferro-electric capacitor and a method for manufacturing the same.

### 2. Description of the Related Art

Recently, among a variety of types of semiconductor memory devices, a Ferro-electric Random Access Memory (FeRAM) that is a semiconductor memory device incorporating therein a ferro-electric capacitor has been increasingly attracting attention. The FeRAM is configured as a non-volatile memory to have advantageous features allowing data to be rewritten to memory cells a number of times and at high rate, and further, a memory cell to be reduced in size.

For example, a FeRAM cell having one transistor and one capacitor is constructed such that the one transistor has its source and drain connected to a bit line and one electrode of ferro-electric capacitor respectively, and its gate connected to a word line, and further, the other electrode of ferro-electric capacitor is connected to a plate line.

Operation for writing data "1" to the FeRAM cell is performed so that a memory cell is selected by a word line and a ferro-electric dielectric of the selected cell is polarized by applying a supply voltage V.sub.cc to the bit line and the ground potential (GND) to the plate line. Operation for writing data "0" to the FeRAM cell is carried out so that the ferro-electric dielectric of the selected cell is polarized by applying the ground potential to the bit line and the supply voltage V. sub. cc to the plate line.

Operation for reading data from a memory cell is performed so that the supply voltage V.sub.cc is applied to the plate line and data stored in the ferro-electric.capacitor is output to the bit line via the transistor selected by the word line, and then, the potential of the bit line is amplified by means of a sense amplifier.

The FeRAM structure having the above-described features is often realized by employing a structure including a ferro-electric capacitor formed on an interconnect stack in terms of reduction in the number of manufacturing steps. The above-described FeRAM structure is constructed such that a lower electrode of the ferro-electric capacitor is connected to a diffusion layer of a transistor and an upper electrode thereof is connected to the plate line. However, when reading data from an associated cell, the voltage V.sub.cc needs to be applied to the upper electrode via the plate line and therefore, the plate line formed at the level higher than the ferro-electric capacitor requires means for connecting the plate line to a conductive layer formed at the level lower than the plate line in order to connect the plate line to a drive transistor for driving a plate line.

A process for forming a ferro-electric capacitor on an interconnect stack is disclosed in Japanese Patent Application No. 11 (1999)-317500 and the following technique has conventionally been known to those skilled in the art.

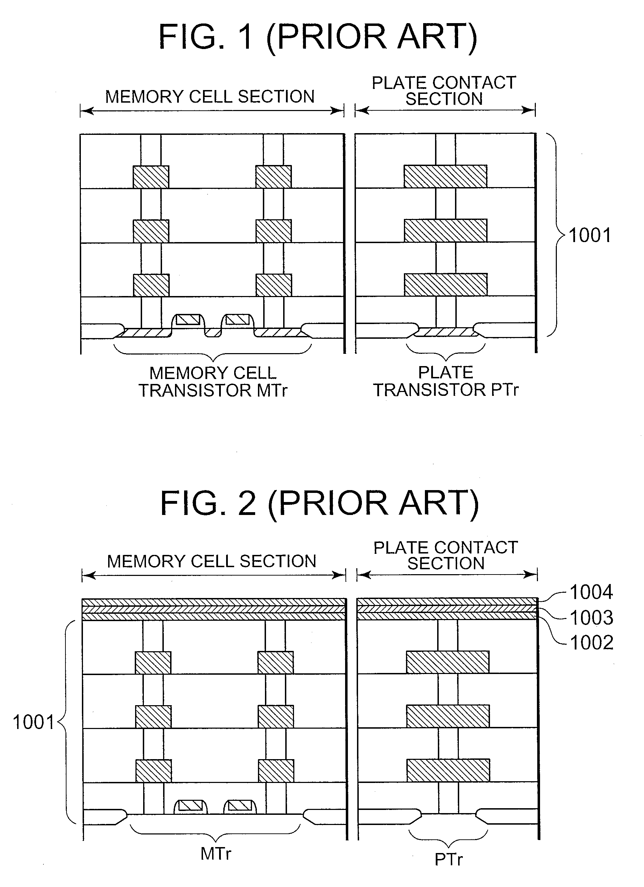

First, a first conventional technique will be explained below with reference to FIGS. 1 through 14. According to the first conventional technique, an upper electrode and a lower electrode of ferro-electric capacitor are formed in independent steps respectively and a pad as a lower electrode is formed in a portion through which a plate line is to be connected to conductive layers formed at the level lower than the plate line.

As shown in FIG. 1, in accordance with a standard CMOS process, a memory cell transistor MTr and a plate transistor PTr are formed and then an interconnect stack 1001 (generally, the stack consists of a number of alternating conductive materials (i. e., conductive layers and contact studs) and insulating dielectric layers, and in this case, includes three conductive layers) is formed. Contact holes are formed in an uppermost dielectric layer of the interconnect stack 1001 to provide electrical connection between a lower electrode of a ferro-electric capacitor and one of source/drain regions of the memory cell transistor in a memory cell section, and further, provide electrical connection between a plate line and one of source/drain regions of the plate transistor in a plate contact section. Subsequently, contact studs made of tungsten, which are positioned on third conductive layers and connected thereto, are formed within the contact holes.

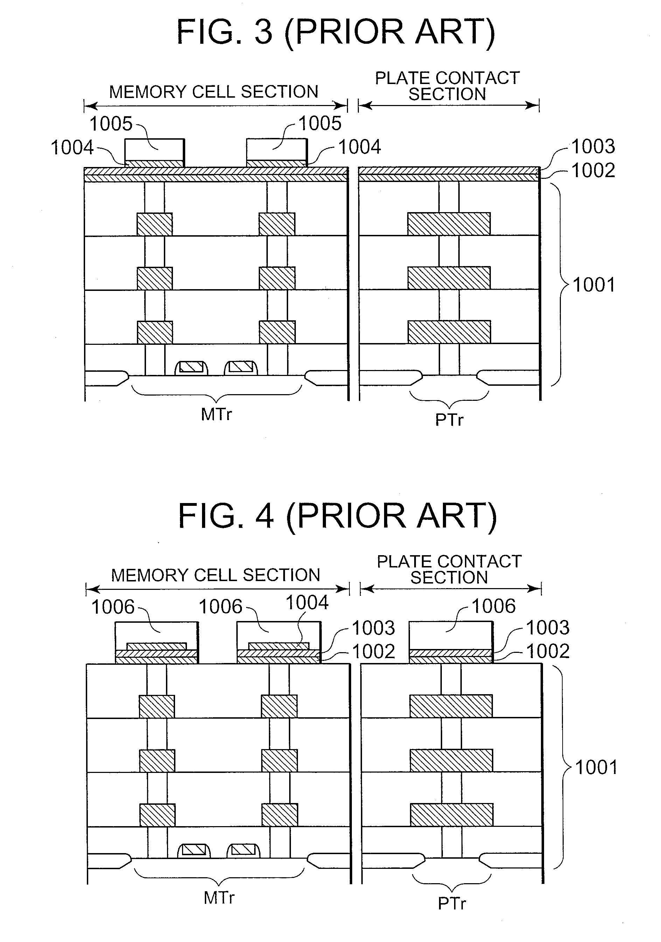

As shown in FIG. 2, a lower electrode layer 1002, a ferro-electric film 1003 and an upper electrode layer 1004 are sequentially deposited so as to cover the uppermost dielectric layer and the contact studs of the interconnect stack. Then, a photoresist mask 1005 is formed to cover desired portions of the upper electrode layer. Thereafter, as shown in FIG. 3, an exposed portion of the upper electrode layer is etched away by use of the mask to form an upper electrode of each of the ferro-electric capacitors. In this case, since the plate contact section does not have the mask 1005 formed thereon, the upper electrode layer 1004 is etched away and the ferro-electric film 1003 is exposed in the plate contact section.

Subsequently, after removal of the mask 1005, aphotoresist mask 1006 is formed to cover desired portions of the ferro-electric film 1003 and to cover at least the upper electrodes 1004. Portions, exposed through the mask 1006, of the ferro-electric film 1003 and the lower electrode layer 1002 are etched away to form a capacitive dielectric film and a lower electrode of the ferro-electric capacitor. In this case, the mask 1006 is simultaneously formed to cover a desired portion of the ferro-electric film 1003 in the plate contact section and the etch is carried out to leave a ferro-electric film 1003 and a lower electrode layer 1002 in the plate contact section.

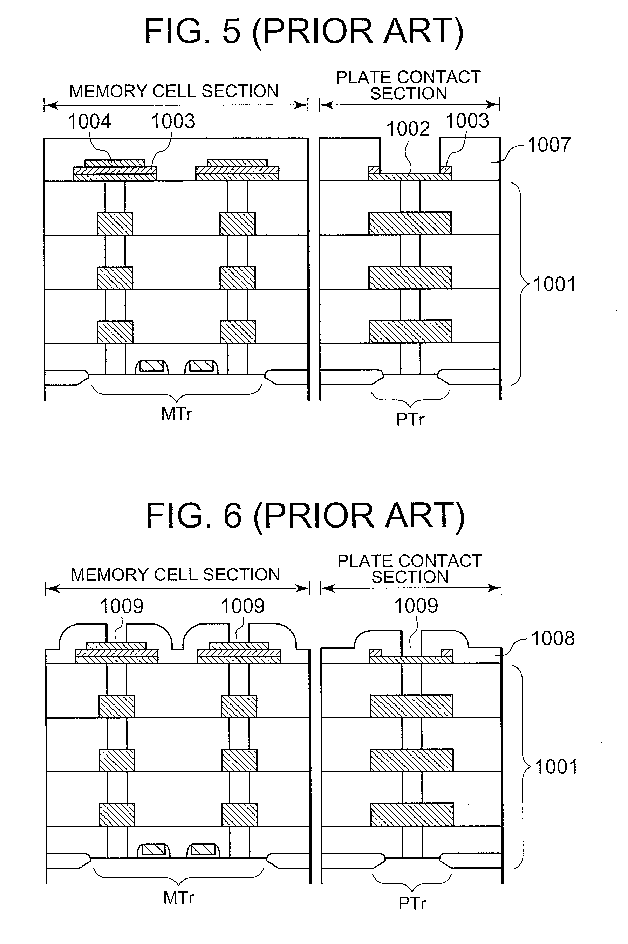

After removal of the mask 1006, the capacitive dielectric film (ferro-electric film) 1003 is etched away by wet etching by use of a photoresist mask 1007 to expose the lower electrode 1002 in the plate contact section, as shown in FIG. 5.

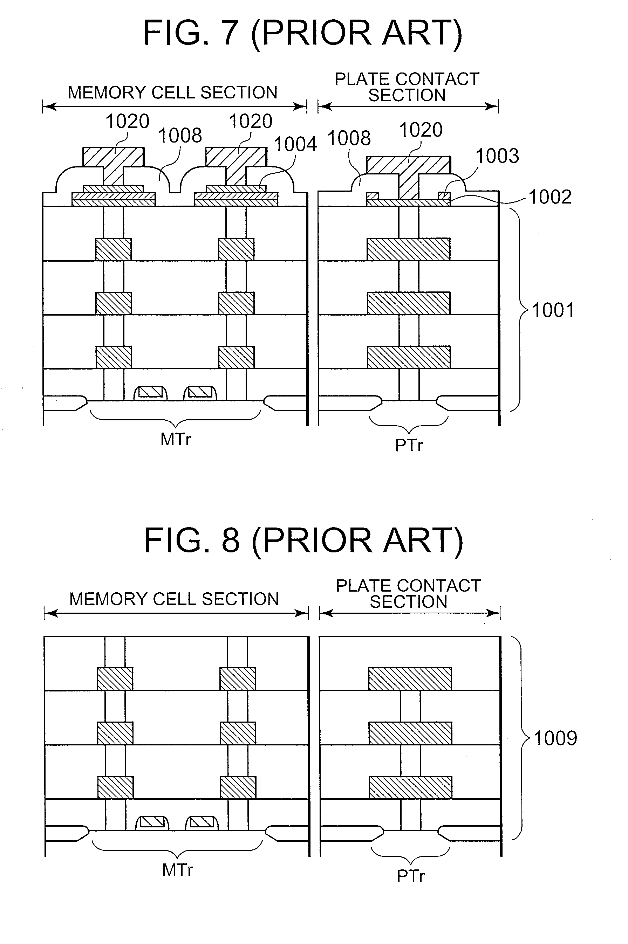

After removal of the mask 1007, a silicon oxide film 1008 is deposited over the entire structure and contact holes 1009 are formed in the film 1008 on the upper electrodes of the ferro-electric capacitor in the memory cell section and in the film 1008 in the plate contact section, as shown in FIG. 6. Then, as shown in FIG. 7, a conductive layer is deposited over the entire structure to fill the contact holes 1009 with a conductive material and patterned to connect the upper electrodes 1004 of the ferro-electric capacitors in the memory cell section to the lower electrode 1002 in the plate contact section via a plate line 1020, thereby connecting together the plate transistor PTr and the upper electrodes 1004 of the ferro-electric capacitors.

Furthermore, a method for forming an upper electrode and a lower electrode using the same lithography step (patterning step using the same mask) in order to reduce the number of process steps has also been proposed. The aforementioned method will be explained below as a second conventional technique.

As shown in FIG. 8, an interconnect stack 1009 is provided and contact studs are formed in an uppermost dielectric layer of the interconnect stack 1009 according to the second conventional technique and similarly to the first conventional technique, but a contact stud is not formed in the uppermost dielectric layer of the interconnect stack 1009 inaplate contact section according to the second conventional technique.

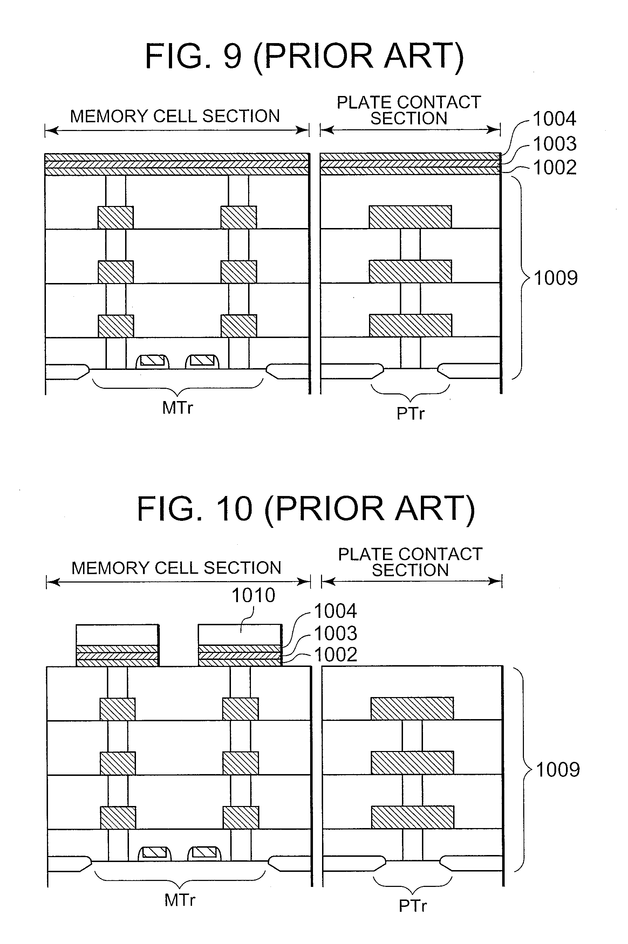

As shown in FIG. 9, a lower electrode layer 1002, a ferro-electric film 1003 and an upper electrode layer 1004 are sequentially deposited on the interconnect stack 1009. Then, as shown in FIG. 10, a mask 1010 is formed on desired portions of the upper electrode layer 1004 and a portion, exposed through the mask 1010, of a lamination consisting of the upper electrode layer 1004, the ferro-electric film 1003 and the lower electrode layer 1002 is etched away. In this case, the lamination consisting of the upper electrode layer 1004, the ferro-electric film 1003 and the lower electrode layer 1002 is etched away and the uppermost insulating dielectric layer of the interconnect stack 1009 is exposed in the plate contact section.

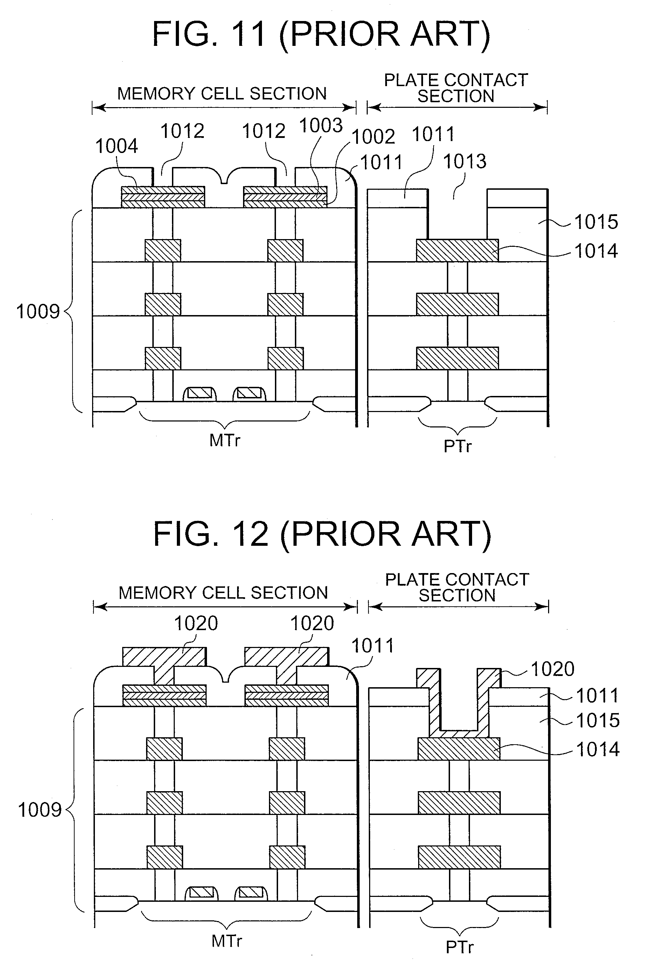

Subsequently, as shown in FIG. 11, a silicon oxide film 1011 is deposited over the entire structure and contact holes 1012 are formed in the silicon oxide film 1011 on the upper electrode 1004 of the ferro-electric capacitor in the memory cell section and a contact hole 1013 is formed in the silicon oxide film 1011 in the plate contact section. Note that in the plate contact section, in addition to the silicon oxide film 1011, an uppermost insulting dielectric layer 1015 overlying a third conductive layer 1014 of the interconnect stack 1009 needs to be etched away and therefore, a contact hole is formed deep. Accordingly, when taking into account the necessity of filling the contact hole 1013 with a conductive material constituting the plate line in order to provide an improved electrical connection between the plate line and the third conductive layer, the contact hole 1013 (hereinafter, referred to as a plate contact hole) in the plate contact section needs to be formed to have a diameter larger than its height, i. e., needs to have a smaller aspect ratio.

Thereafter, similarly to the first conventional technique, a plate line is formed to provide electrical connection between the plate contact section and the memory cell section via the plate line, as shown in FIG. 12.

Subsequently, a third conventional technique will be explained below. According to the third conventional technique, an interconnect stack 1001 is formed and then an upper electrode layer, a ferro-electric film and a lower electrode layer are patterned using the same lithography step, thereby reducing the number of process steps.

Process steps beginning with the first step to the step shown in FIG. 2 that illustrates a lower electrode layer 1002, a ferro-electric film 1003 and an upper electrode layer 1004 formed on the interconnect stack 1001 are the same as those shown in the first conventional technique and therefore, the explanation thereof is omitted for simplification.

First, a photoresist mask 1016 is optionally formed on desired portions of the upper electrode layer 1004 in the memory cell section and a lamination consisting of the lower electrode layer 1002, the ferro-electric film 1003 and the upper electrode layer 1004 is etched away by use of the mask to form ferro-electric capacitors in the memory cell section. In this case, since the plate contact section does not have the mask formed thereon, the lamination consisting of the lower electrode layer 1002, the ferro-electric film 1003 and the upper electrode layer 1004 in the plate contact section is etched away, thereby exposing the uppermost insulating dielectric layer and the uppermost contact stud of the interconnect stack in the plate contact section.

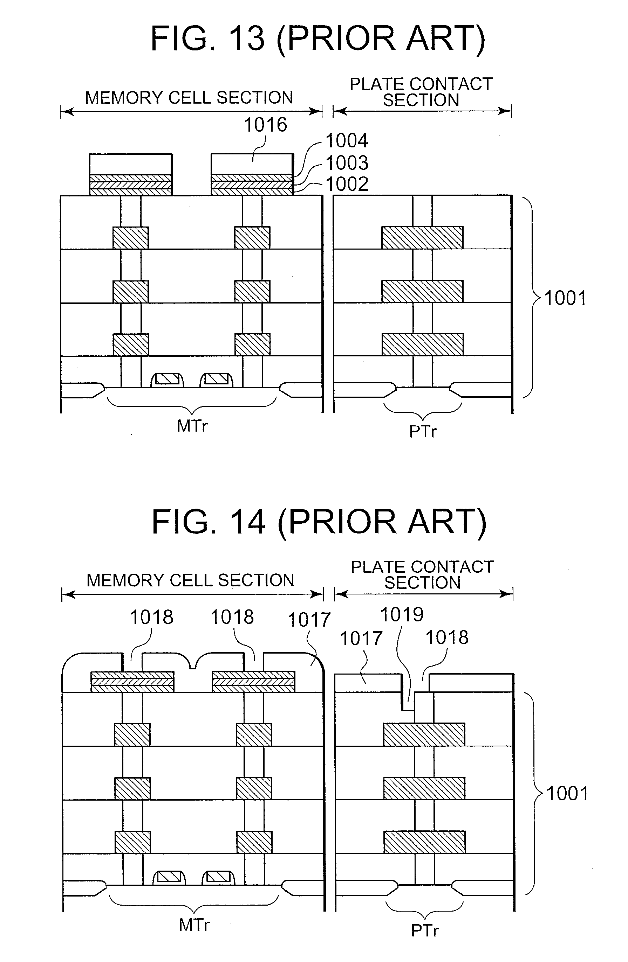

Subsequently, the mask 1016 is removed and as shown in FIG. 14, a silicon oxide.film 1017 is formed over the entire structure; and contact holes 1018 are formed in the silicon oxide film 1017 on the upper electrodes in the memory cell section and in the film 1017 on the contact stud in the plate contact section. Then, similarly to the first conventional technique, a conductive film is deposited and patterned to form a plate line for providing an electrical connection between the upper electrodes and the contact stud.

As described above, the first conventional technique for forming an upper electrode and a lower electrode in independent steps needs to ensure that an upper electrode is formed smaller than a lower electrode in order to give some tolerance available for alignment errors between the upper electrode and the lower electrode, resulting in reduction in effective area of ferro-electric capacitor. Furthermore, after formation of the lamination consisting of the upper electrode layer, the ferro-electric film and the lower electrode layer, many mask formation steps, i. e., three mask formation steps, need to be carried out until formation of silicon oxide film 1008. The three mask formation steps are performed as follows. That is, (1) a first mask formation step is performed such that a first mask is formed to cover desired portions of an upper electrode layer and the upper electrode is etched using the first mask, and then, the first mask is removed. (2) A second mask formation step is performed such that a second mask is formed to cover desired portions of a lamination consisting of ferro-electric film and lower electrode layer and the lamination is etched using the second mask, and then, the second mask is removed. (3) A third mask formation step is performed such that a third mask is formed to expose a desired portion of the ferro-electric film in the plate contact section and the desired portion of the ferro-electric film is etched using the third mask, and after removal of the third mask, a silicon oxide film is formed.

Since the second conventional technique includes simultaneously forming an upper electrode and a lower electrode, the ferro-electric film can be formed to provide a large. capacitance. However, since a plate contact hole is formed to have a depth that equals a depth calculated by summing the thickness of a silicon oxide film on the capacitor and the thickness of the uppermost insulating film of the interconnect stack, the contact hole in the plate contact section needs to have an aspect ratio that allows a conductive material (e. g., aluminum) for a plate line to successfully be formed within the contact hole. That is, the contact hole needs to be formed to have a large diameter comparable to the depth of the contact hole. However, it is difficult to form contact holes having a large diameter for conductive studs that make electrical connection to each plate line.

Similarly to the second conventional technique, the third conventional technique includes simultaneously forming the upper electrode and the lower electrode and therefore, the ferro-electric capacitor can be formed to have a large capacitance. However, as shown in FIG. 14, misalignment of the contact hole 1018 relative to the uppermost contact stud of the interconnect stack in the plate contact section increases the aspect ratio of a hole depth to a hole diameter in a portion where the uppermost insulating dielectric film of the interconnect stack is over-etched and therefore, when the plate line is formed displaced to a large extent from a desired position relative to the contact hole, the contact hole cannot be filled with a metal material that constitutes the plate line, creating a void in the contact hole. Gas within the void expands in a subsequent heat treatment step and pushes upward the metal material that constitutes the plate line and should have been filled within the contact hole, causing failure of the connection between the contact stud and the plate line.

As described above, even when employing any of the aforementioned conventional techniques, a semiconductor manufacturer still faces the problem of reducing the size of ferro-electric capacitor. That is, the upper electrode and the lower electrode of ferro-electric capacitor cannot be formed to have the same area, i. e., operation for maximizing the areas, facing each other, of the upper electrode and the lower electrode of ferro-electric capacitor, and further, reducing the diameter of the plate contact hole is impossible to perform. Accordingly, any conventional technique cannot satisfy the need for a FeRAM structure having a plate line connected to an upper electrode of ferro-electric capacitor.

### SUMMARY OF THE INVENTION

An object of the present invention is to provide a FeRAM structure having a ferro-electric capacitor formed on an interconnect stack and being capable of maximizing opposing areas of upper and lower electrodes of the ferro-electric capacitor and reducing a diameter of a plate contact hole (i.e., a reliable contact hole defined so that electrical disconnection between a contact stud and a plate line within a plate contact hole is prevented).

A semiconductor memory device according to a first aspect of the present invention includes: a semiconductor substrate; a memory cell section including a memory cell transistor formed on the semiconductor substrate; a plate contact section including a plate transistor formed on the semiconductor substrate; a first interlayer insulation film formed on the semiconductor substrate to cover the memory cell transistor and the plate transistor; an etch stop layer formed on the first interlayer insulation film; a ferro-electric capacitor including a lower electrode connected to the memory cell transistor, a ferro-electric film and an upper electrode, and formed on the etch stop layer in the memory cell section; a second interlayer insulation film formed on an entire surface of the substrate to cover the ferro-electric capacitor; a first contact hole corresponding to the ferro-electric capacitor and formed in the second interlayer insulation film in the memory cell section to expose the upper electrode of the ferro-electric capacitor; a second contact hole formed in the second interlayer insulation film in the plate contact section; and a plate line provided to connect the upper electrode and the plate transistor through the first contact hole and the second contact hole.

A semiconductor memory device according to a second aspect' of the present invention includes: a semiconductor substrate; a memory cell transistor having source and drain regions formed in the semiconductor substrate; a first interlayer insulation film formed on the semiconductor substrate to cover the memory cell transistor; an insulating layer formed on the first interlayer insulation film and made of such a material that resists an etchant etching an overlying layer directly covering the insulating layer; a ferro-electric capacitor including a lower electrode formed on the insulating layer, a ferro-electric film formed on the lower electrode and an upper electrode formed on the ferro-electric film; and a first contact stud selectively formed in the insulating layer and the first interlayer insulation film to provide a conductive path between one of the source and drain regions of the memory cell transistor and the lower electrode of the ferro-electric capacitor. The device according to the second aspect of the invention further includes a plate transistor having source and drain regions formed in the semiconductor substrate; a second interlayer insulation film formed on the insulating film and provided as the overlying layer to cover the ferro-electric capacitor; a first contact hole formed in the second interlayer insulation film to expose the upper electrode of the ferro-electric capacitor; a second contact hole formed in the second interlayer insulation film and located above one of the source and drain regions of the plate transistor; a second contact stud selectively formed in the insulating film and the first interlayer insulation film to make electrical connection to one of the source and drain regions of the plate transistor; and a plate line providing an electrical connection between the upper electrode of the ferro-electric capacitor and the second contact stud.

A semiconductor memory device according to a third aspect of the present invention incorporates therein a memory cell transistor having a ferro-electric capacitor, and a plate transistor connected to an upper electrode of the ferro-electric capacitor, and the plate transistor includes: source and drain regions selectively formed in a semiconductor substrate; a first layer insulation film covering the source and drain regions; an insulating layer formed on the first interlayer insulation film and made of a material different from that making up the first interlayer insulation film; a contact stud selectively formed in the first interlayer insulation film and the insulting layer to make electrical connection to one of the source and drain regions of the plate transistor; a second interlayer insulation film formed on the insulating layer; and a contact hole formed in the second interlayer insulation film to provide electrical connection between the contact stud and the upper electrode of the ferro-electric capacitor.

The etch stop layer or the insulating layer according to the above-described aspects of the invention provides an effective component to prevent formation of an unfavorable groove in the interlayer insulation film underlying the etch stop layer or the insulating layer and beside the contact stud formed in the interlayer insulation film above the plate transistor, which groove causes disconnection between the plate line and the contact stud above the plate transistor.

According to an alternative aspect of the invention, there are derived methods of producing a semiconductor memory device that are described below:

A method for manufacturing a semiconductor memory device according to the alternative aspect of the invention includes: forming a first interlayer insulation film on a semiconductor substrate having a memory cell transistor and a plate transistor thereon; forming an etch stop layer on the first interlayer insulation film; forming a first contact stud penetrating the etch stop layer and the first interlayer insulation film to make electrical connection to the memory cell transistor, as well as a second contact stud penetrating the etch stop layer and the first interlayer insulation film to make electrical connection to the plate transistor; depositing sequentially a lower electrode layer, a ferro-electric film and an upper electrode layer covering the first and second contact studs and the etch stop layer; etching away desired portions of the upper electrode layer, the ferro-electric film and the lower electrode layer to form a ferro-electric capacitor connected to the first contact stud, while removing portions, positioned on the second contact stud, of the upper electrode layer, the ferro-electric film and the lower electrode layer; forming a second interlayer insulation film covering the ferro-electric capacitor and the etch stop layer; and forming third contact holes in portions of the second interlayer insulation film corresponding to the ferro-electric capacitor and the second contact stud by way of etching process utilizing the etch stop layer against the second interlayer insulation film.

It is also convenient that the above-mentioned method further includes: depositing a conductor layer on the second interlayer insulation film to fill the third contact holes with a material making up the conductor layer to connect the upper electrode layer of the ferro-electric capacitor and the second contact stud to each other, or the above-mentioned method further includes: planarizing the second interlayer insulation film before forming third contact holes in portions of the second interlayer insulation film corresponding to the ferro-electric capacitor and the second contact stud. In the latter case, the above-mentioned method further includes: depositing a conductor layer on the second interlayer insulation film to fill the third contact holes with a material making up the conductor layer to connect the upper electrode layer of the ferro-electric capacitor and the second contact stud to each other, or the above-mentioned method further includes: filling the third contact holes formed in portions of the second interlayer insulation film corresponding to the ferro-electric film and the second contact stud with a conductive material to form third and fourth contact studs, and forming a plate line for providing electrical connection between the third and fourth contact studs.

As described above, since the etch stop layer is used as an etch stop in the step of forming contact holes in the second interlayer insulation film, the first interlayer insulation film around the second contact stud that is provided to make electrical connection to the plate transistor never be etched. This reduces probability of occurrence of failure of a physical and electrical connection between the second contact stud and the plate line.

### BRIEF DESCRIPTION OF THE DRAWINGS

FIG. 1 is a cross sectional view of a semiconductor memory device, illustrating a method for manufacturing a semiconductor memory device according to a first conventional technique in the order of manufacturing steps;
FIG. 2 is a cross sectional view of the semiconductor memory device, illustrating a step subsequent to the step shown in FIG. 1;
FIG. 3 is a cross sectional view of the semiconductor memory device, illustrating a step subsequent to the step shown in FIG. 2;
FIG. 4 is a cross sectional view of the semiconductor memory device, illustrating a step subsequent to the step shown in FIG. 3;
FIG. 5 is across sectional view of the semiconductor memory device, illustrating a step subsequent to the step shown in FIG. 4;
FIG. 6 is a cross sectional view of the semiconductor memory device, illustrating step subsequent to the step shown in FIG. 5;
FIG. 7 is a cross sectional view of the semiconductor memory device, illustrating a step subsequent to the step shown in FIG. 6;
FIG. 8 is a cross sectional view of a semiconductor memory device, illustrating a method for manufacturing a semiconductor memory device according to a second conventional technique in the order of manufacturing steps;
FIG. 9 is across sectional view of the semi conductor memory device, illustrating a step subsequent to the step shown in FIG. 8;
FIG. 10 is a cross sectional view of the semiconductor memory device, illustrating a step subsequent to the step shown in FIG. 9;
FIG. 11 is a cross sectional view of the semiconductor memory device, illustrating a step subsequent to the step shown in FIG. 10;
FIG. 12 is a cross sectional view of the semiconductor memory device, illustrating a step subsequent to the step shown in FIG. 11;
FIG. 13 is a cross sectional view of a semiconductor memory device, illustrating a method for manufacturing a semiconductor memory device according to a third conventional technique in the order of manufacturing steps;
FIG. 14 is a cross sectional view of the semiconductor memory device, illustrating a step subsequent to the step shown in FIG. 13;
FIG. 15 is a cross sectional view of a semiconductor memory device according to a first embodiment of the invention;
FIG. 16 is a plan view of the semiconductor memory device according to the first embodiment of the invention;
FIG. 17 is an enlarged plan view of the semiconductor memory device according to the first embodiment of the invention;
FIG. 18 is a cross sectional view of a semiconductor memory device, illustrating a method for manufacturing a semiconductor memory device according to the first embodiment of the invention in the order of manufacturing steps;
FIG. 19 is a cross sectional view of the semiconductor memory device, illustrating a step subsequent to the step shown in FIG. 18;
FIG. 20 is a cross sectional view of the semiconductor memory device, illustrating a step subsequent to the step shown in FIG. 19;
FIG. 21 is a cross sectional view of the semiconductor memory device, illustrating a step subsequent to the step shown in FIG. 20;
FIG. 22 is a cross sectional view of the semiconductor memory device, illustrating a step subsequent to the step shown in FIG. 21;
FIG. 23 is a cross sectional view of the semiconductor memory device, illustrating a step subsequent to the step shown in FIG. 22;
FIG. 24 is a cross sectional view of a semiconductor memory device, illustrating a method for manufacturing a semiconductor memory device according to a second embodiment of the invention in the order of manufacturing steps;
FIG. 25 is a cross sectional view of the semiconductor memory device, illustrating a step subsequent to the step shown in FIG. 24;
FIG. 26 is a cross sectional view of a semiconductor memory device, illustrating a method for manufacturing a semiconductor memory device according to a third embodiment of the invention in the order of manufacturing steps; and
FIG. 27 is a cross sectional view of the semiconductor memory device, illustrating a step subsequent to the step shown in FIG. 26.

### DETAILED DESCRIPTION OF THE PREFERRED EMBODIMENTS

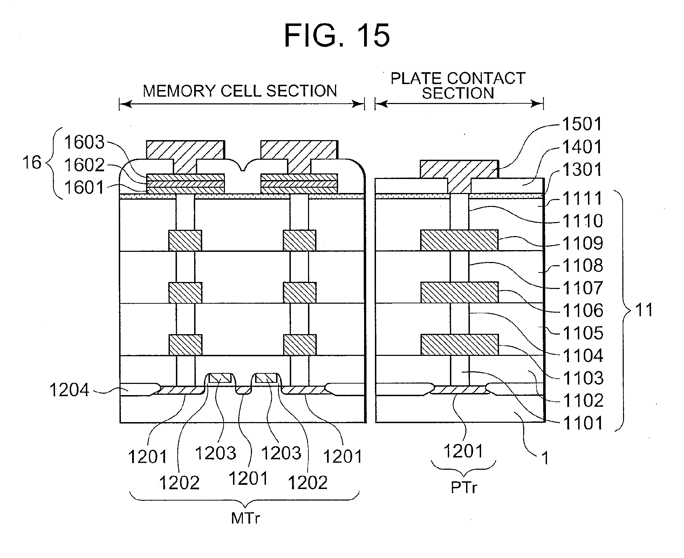

Embodiments of the invention will be explained in detail below with reference to the accompanying drawings. As shown in FIG. 15, a FeRAM according to a first embodiment of the invention is constructed such that in a memory cell section, a lower electrode 1601 of a ferro-electric capacitor 16 is formed on a contact stud 1110 that is formed to penetrate an interlayer insulation film 1111 and an insulation film 1301, and in a plate contact section, a plate line 1501 is formed on a contact stud 1110 that is formed to penetrate the interlayer insulation film 1111 and the insulation film 1301. The plate line 1501 in the plate contact section is formed to extend to the memory cell section and connected to an upper electrode 1603 of the ferro-electric capacitor 16. Note that a diffusion region 1201 of a memory cell transistor MTr formed in the memory cell section on a semiconductor substrate 1 and the corresponding lower electrode 1601 of the ferro-electric capacitor 16 are connected to each other through an interconnect stack 11 (consisting of a number of alternating conductive materials (i. e., conductive layers and studs) and interlayer insulation films).

The interconnect stack 11 comprises a first level contact stud 1101, a first interlayer insulation film 1102, a first level conductive layer 1103, a second level contact stud 1104, a second interlayer insulation film 1105, a second level conductive layer 1106, a third level contact stud 1107, a third interlayer insulation film 1108, a third level conductive layer 1109, a fourth level contact stud 1110, and a fourth interlayer insulation film 1111. Explanation of how the interconnect stack 11 is formed is omitted for simplification.

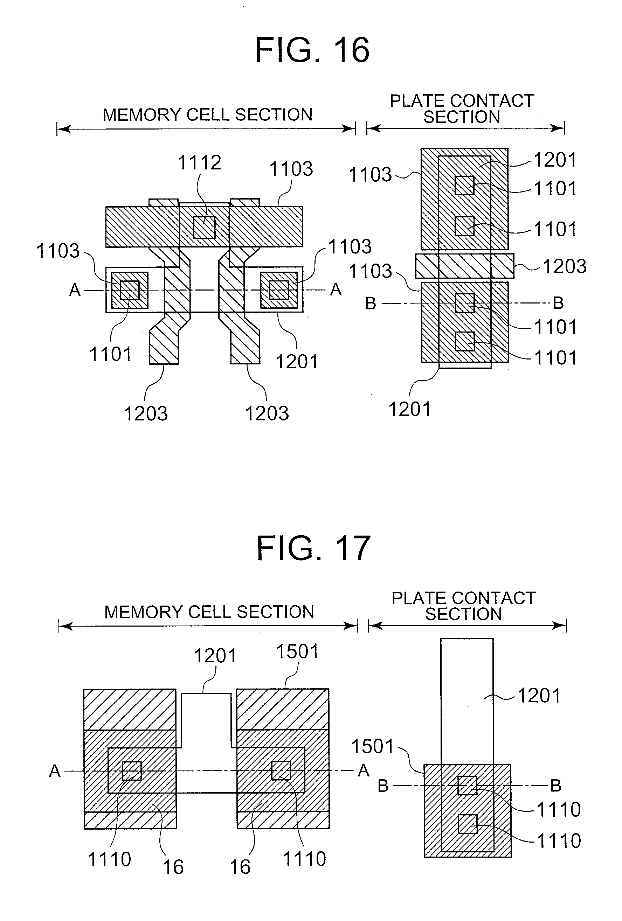

Subsequently, a memory cell structure and a plate contact structure will be explained with reference to plan views shown in FIGS. 16 and 17.

In the memory cell section, a memory cell transistor MTr comprises N.sup.+diffusion layers (source and drain) 1201 formed in a P-type semiconductor substrate 1, a gate insulating film 1202 made from a silicon oxide film, and a gate electrode 1203 formed of polysilicon or silicided polysilicon. In this case, one of the N.sup.+ diffusion layers is connected to a bit line constituted by the first level conductive layer (aluminum interconnect) and the other of the N.sup.+ diffusion layers is connected to the lower electrode 1601, formed thereabove, of the ferro-electric capacitor 16 through the first to fourth level contact studs 1101, 1104, 1107, 1110 each comprising tungsten and the first to third level conductive layers 1103, 1106, 1109; In this case, the ferro-electric capacitor 16 comprises a lower electrode 1601 formed of a lamination consisting of titanium film, titanium nitride film and platinum film laminated in this order, a ferro-electric film 1602 made of PbZr.sub.X.Ti.sub.(1-X).O.sub.3 (PZT), and an upper electrode 1603 formed of a lamination consisting of iridium oxide film and iridium film laminated in this order.

In the plate contact section, a plate transistor PTr provided to apply a voltage to a plate line 1501 comprises N.sup.4- + diffusion layers (source and drain) 1201 formed in the P-type semiconductor substrate 1, a gate insulating film 1202 and a gate electrode 1203. In this case, one of the N.sup.+ diffusion layers is connected to aplate line 1501 formed thereabove through the first to fourth level contact studs 1101, 1104, 1107, 1110 and the first to third level conductive layers 1103, 1106, 1109.

Formed as an insulation film 1301 on the upperside surface of each of uppermost level tungsten studs constituting a fourth level contact stud is a silicon nitride film or a lamination consisting of silicon nitride film and silicon oxide film formed atop the silicon nitride film. In this case, the plate line 1501 provides an electrical connection between the upper electrode 1603, formed in the memory cell section, of the ferro-electric capacitor 16 and the fourth level contact stud 1110 in the plate contact section. The insulation film 1301 serves as an etch stop capable of stopping the etch at the surface of the insulation film 1301 when forming a contact hole directly above the fourth level contact stud 1110.

Accordingly, in a case where misalignment of a contact hole relative to an uppermost contact stud of the interconnect stack occurs when forming a contact hole in a silicon oxide film 1401 or a plate contact hole is formed to have a diameter larger than that of the fourth level contact stud 1110, even if the plate contact is formed being displaced from a desired position relative to the fourth level contact stud 1110, over-etching, potentially creating a void, of the silicon oxide film 1401 in forming a plate contact hole never occurs, preventing failure of a connection between contact portions. Note that in the embodiment, the silicon oxide film 1401 is formed as a second uppermost level of insulating layer underlying an uppermost level of insulating layer (not shown). Furthermore, contact hole formation limited to within the silicon oxide film 1401 eliminates the need for enlargement of diameter of contact hole in the plate contact section and advantageously simplifies design of contact hole and plate line provided in the plate contact section.

Subsequently, a method for manufacturing the aforementioned structure according to the first embodiment of the invention will be explained with reference to the drawings.

First, in accordance with a standard CMOS process, a memory cell transistor MTr and a plate transistor PTr are formed on a semiconductor substrate 1 and then an interconnect stack 11 is formed on the semiconductor substrate to cover those transistors. In this case, the interconnect stack 11 comprises: a first level contact stud 1101 made of-tungsten; a first interlayer insulation film 1102 made from a silicon oxide film; a first level conductive layer 1103 made of aluminum; a second level contact stud 1104 made of tungsten; a second interlayer insulation film 1105 made from a silicon oxide film; a second level conductive layer 1106 made of aluminum; a third level contact stud 1107 made of tungsten; a third interlayer insulation. film 1108 made from a silicon oxide film; and a third level conductive layer 1109 made of aluminum and formed on the third interlayer insulation film 1108. The interconnect stack 11 further comprises: a fourth interlayer insulation film 1111 made from a silicon oxide film and deposited overlying the third level conductive layer 1109, and planarized using chemical mechanical polishing (CMP) ; and an etch stop layer 1301 deposited by plasma CVD over the fourth interlayer insulation film 1111 and formed from one selected from a group consisting of a silicon nitride film having a thickness of about 100 nm, a silicon oxynitride film having a thickness of about 100 nm, a lamination comprised of silicon nitride film having a thickness of about 100 nm and silicon oxide film having a thickness of about 30 nm and formed a top the silicon nitride film, and a lamination comprised of silicon oxynitride film having a thickness of about 100 nm and silicon oxide film having a thickness of about 30 nm and formed atop the silicon oxynitride film.

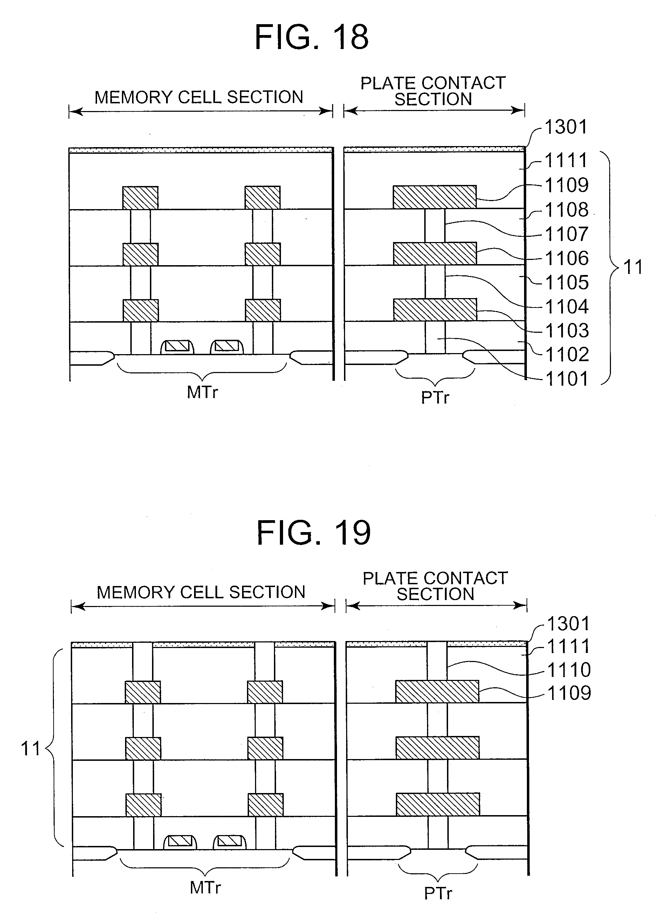

After formation of the interconnect stack, a photoresist mask (not shown) is formed on the etch stop layer 1301 and a contact hole reaching the third level conductive layer 1109 is formed using the mask. In this case, if the etch stop layer 1301 is made from a silicon nitride film, the contact hole is formed by successively etching the etch stop layer 1301 and the fourth interlayer insulation film 1111 using, for example, gas containing CF. sub. 4 . Thereafter, as shown in FIG. 19, a titanium film and a titanium nitride film (e. g., the titanium film having a thickness of about 15 nm and the titanium nitride film having a thickness of about 50 nm) are successively deposited by sputtering to cover the third level conductive layer 1109, and further, a tungsten film is deposited by CVD so as to fill the contact hole. Then, the tungsten film is etched back to leave tungsten within the contact hole, forming a tungsten stud 1110. Furthermore, the titanium film and the titanium nitride film formed also on the etch stop layer 1301 are polished away using CMP. Note that the titanium film and the titanium nitride film are formed as a barrier metal between the aluminum interconnect lines as a third level conductive layer and the tungsten stud.

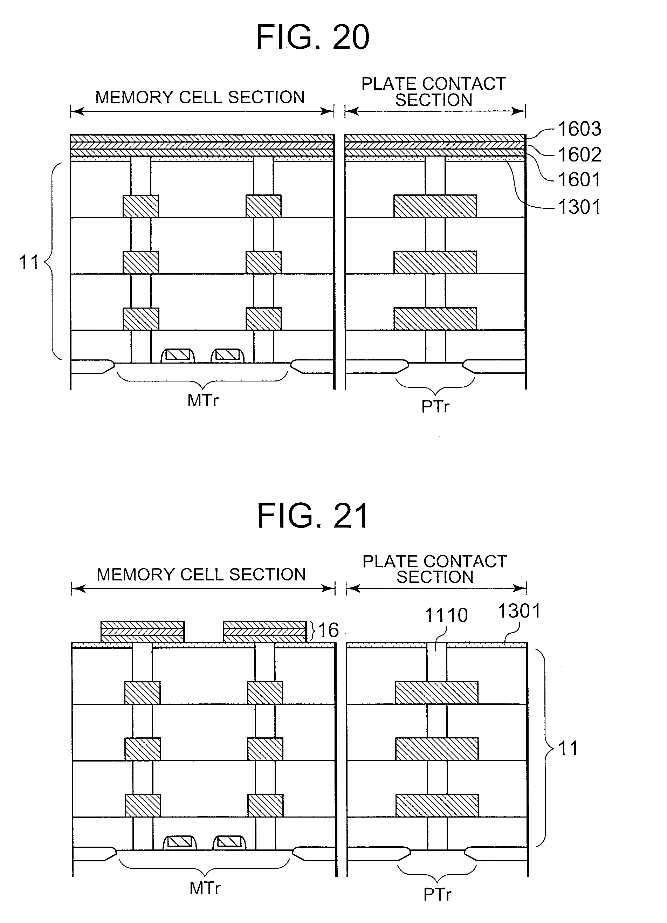

Subsequently, as shown in FIG. 20, a titanium film, a titanium nitride film and a platinum film (e. g., the titanium film having a thickness of about 20 nm, the titanium nitride film having a thickness of about 50 nm, the platinum film having a thickness of about 100 nm) are deposited in order on the etch stop layer 1301 to form a lower electrode layer 1601. Then, a ferro-electric film 1602 such as a PZT film is formed on the lower electrode layer 1601 to have a thickness of about 250 nm and an iridium oxide film having a thickness of about 50 nm and an iridium film having a thickness of about 50 nm are deposited in order to form an upper electrode layer 1603.

Thereafter, to form a ferro-electric capacitor in a memory cell section, desired portions of the memory cell section are covered with a mask and subjected to a dry etching step so as to form a ferro-electric capacitor 16 that covers the contact stud. The upper electrode layer is dry-etched using a gas mixture formed from Cl.sub.2/Ar and the PZT film is dry-etched using a gas mixture formed from BCl.sub.3/Ar, and the lower electrode layer is dry-etched using a gas mixture formed from Cl.sub.2/Ar. In the dry etching step, the photoresist mask is etched and reduced to a large extent in thickness, and therefore, becomes difficult to serve as a mask. Accordingly, the etching step is carried out using a hard mask such as a silicon oxide film. In the embodiment, a silicon oxide film having a thickness of about 600 nm is used as a hard mask. Since the plate contact section does not have a mask formed thereon, the lower electrode layer 1601, the ferro-electric film 1602 and the upper electrode layer 1603 in the plate contact section are all etched away. Accordingly, in the plate contact section, the etch stop layer 1301 and the contact stud 1110 are exposed. Note that when employing a silicon oxide film as a hard mask, the silicon oxide film having a thickness of about 100 nm to 200 nm is left on each of the upper electrodes 1603 in the memory cell section.

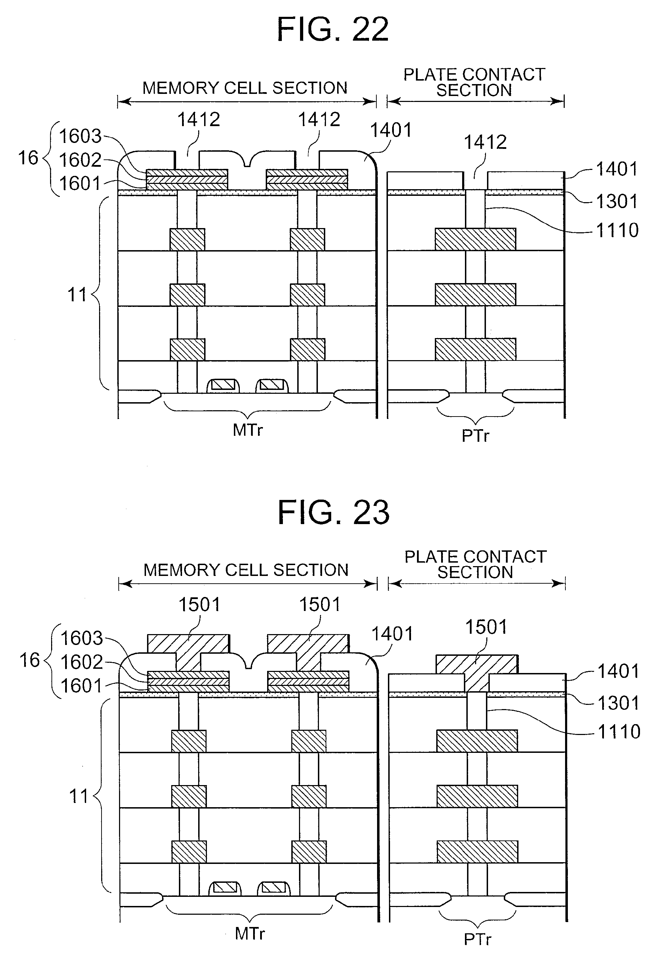

Thereafter, the mask made from a silicon oxide film is removed and if necessary, the entire structure is annealed in an oxygen atmosphere or nitrogen atmosphere. Although the annealing step is performed to remove from the ferro-electric capacitor damage that is applied to the ferro-electric capacitor during formation of the ferro-electric capacitor, if the step is considered unnecessary, it may be omitted. Then, as shown in FIG. 22, an interlayer insulation film 1401 made from a silicon oxide film is deposited over the entire structure to have a thickness of about 500 nm and contact holes (in this case, each hole is formed to have a diameter of, for example, 0.4 µm and a depth of, for example, 500 nm, which depth is the same as the thickness of the interlayer insulation film 1401) are formed, using the etch stop layer 1301 as an etch stop, in the interlayer insulation film 1401 on the upper electrodes of the ferro-electric capacitor and on the tungsten stud in the plate contact section. In this case, the interlayer insulation film 1401 is selectively etched against the etch stop layer 1301 using, for example, a mixture of C.sub.4 F.sub.8, CO, Ar and O.sub.2. Furthermore, if needed, to remove from associated components damage that is applied thereto during formation of the contact holes, an annealing step is carried out in an oxygen atmosphere or nitrogen atmosphere. Although the annealing step is performed to remove from the ferro-electric capacitor damage that is applied thereto during the etching step for formation of contact hole, if the annealing step is considered unnecessary, it may be omitted.

Although in the embodiment, the step of annealing a substrate is performed after removal of the mask left on the upper electrode 1603, the annealing step may be performed in a situation in which the silicon oxide film is being left on the upper electrode 1603.

Subsequently, a lamination consisting of a lower titanium nitride film having a thickness of about 120 nm, an aluminum film having a thickness of about 300 nm and an upper titanium nitride film having a thickness of about 30 nm is formed over the entire structure and patterned to form a plate line 1501 that provides an electrical connection between the upper electrode 1603 of the ferro-electric capacitor 16 and the contact stud 1110 in the plate contact section, as shown in FIG. 23.

As described above, in the method employed in the embodiment,'the etch stop layer 1301 formed from a silicon nitride film or an silicon oxynitride film is formed on the upperside surface of the contact stud 1110 formed in the fourth interlayer insulation film. The etch of the silicon nitride film or the silicon oxynitride film can be highly selective to a silicon oxide film. Accordingly, when a desired portion of the interlayer insulation film 1401 is etched away to form the plate contact hole on the contact stud 1110 and expose the etch stop layer (i. e., the silicon nitride film or the silicon oxynitride film), the.etch is delayed by the etch stop layer, thereby preventing the fourth interlayer insulation film 1111 made from a silicon oxide film underlying the etch stop layer from being etched. Accordingly, even when the plate contact hole is formed being displaced from a desired position relative to the fourth level contact stud 1110 because of, for example, misalignment of the plate contact hole relative to the contact stud, an electrical connection between the fourth level contact stud 1110 and the plate line never becomes defective. Additionally, the interlayer insulation film on the ferro-electric capacitor and the interlayer insulation film on the fourth level contact stud 1110 are being formed to have the same thickness. Accordingly, the plate contact hole provided in the silicon oxide film 1401 in the plate contact section and the contact hole provided on the upper electrode 1603 of the ferro-electric capacitor 16 may be designed to have the same diameter. This advantageously simplifies design of contact hole and plate line provided in the plate contact section.

In the aforementioned first embodiment, the case where the interlayer insulation film on the ferro-electric capacitor is not planarized has been explained. A second embodiment as a case where an interlayer insulation film on a ferro-electric capacitor is planarized will be explained below. Note that the steps performed up to the point where a ferro-electric capacitor is formed are the same as those explained in the description of the first embodiment and shown in FIGS. 17 through 21, and therefore, explanation thereof is omitted for simplification.

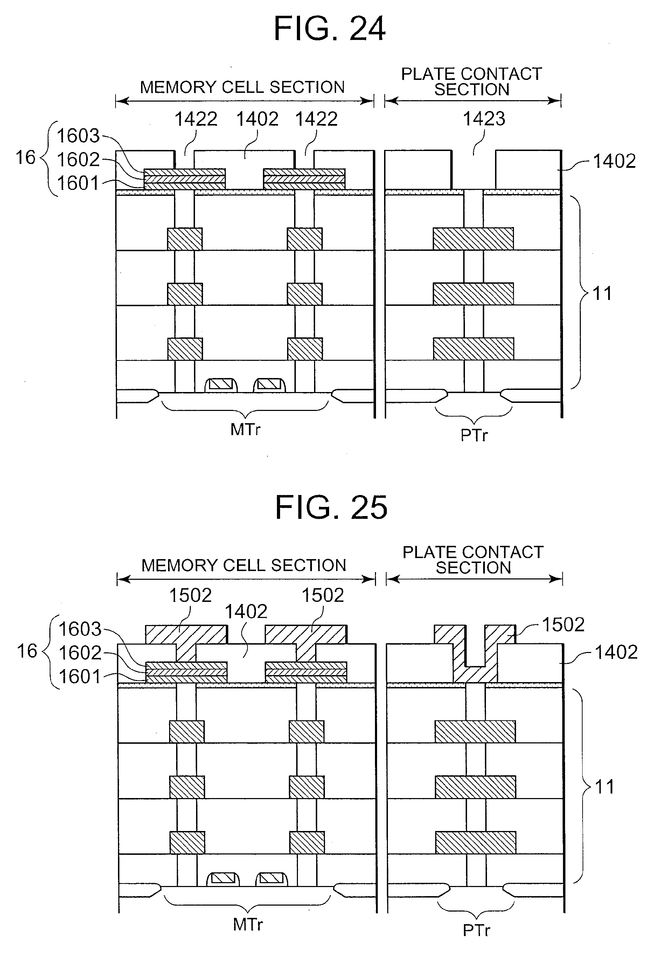

Beginning with the structure shown in FIG. 21, an interlayer insulation film 1402 made from a silicon oxide film is deposited over the entire structure and planarized using CMP, as shown in Fig. 24, and contact holes are formed, using the etch stop layer 1301 as an etch stop, in the interlayer insulation film on the upper electrode 1603 of each of the ferro-electric capacitors 16 and on the fourth contact stud 1110 in the plate contact section. In this case, the interlayer insulation film 1402 is formed on the upper electrode 1603 of each of the ferro-electric capacitors 16 to have a thickness of, for example, about 400 nm. Furthermore, aplate contact hole (e. g., diameter: about 1.0 µm, depth: about 1000 nm) is formed to have a small aspect ratio and a diameter larger than that of the contact hole (e. g., diameter: about 0.4 µm, depth: about 400 nm) formed on the upper electrode of the ferro-electric capacitor 16. Moreover, if needed, to remove from associated components damage created during the process, i.e., to remove from the ferro-electric capacitor damage that is applied thereto during the etching step for formation of contact hole, an annealing step is carried out in an oxygen atmosphere or nitrogen atmosphere.

Subsequently, as shown in FIG. 25, a lamination consisting of titanium nitride film, aluminum film and titanium nitride film is formed over the entire structure and patterned to form a plate line 1501 that provides an electrical connection between the upper electrode 1603 of the ferro-electric capacitor 16 and the contact stud 1110 in the plate contact section.

As described above, according to the second embodiment, the interlayer insulation film is planarized and therefore, formation of plate line becomes facilitated, and the probability of breaking of the plate line and failure of a connection between the plate line and a conductive film connected thereto can advantageously and significantly be reduced.

Although the structure shown in the aforementioned first and second embodiments is formed so that an electrical and physical connection between the plate line and the upper' electrode of the ferro-electric capacitor and between the plate line andthe tungsten stud in the plate contact section is achieved by filling contact holes with the same conductive material as that used to form the plate line, the connection therebetween may be achieved through a contact stud. The structure employed to achieve such connection through a contact stud will be shown as a third embodiment with reference to the drawings.

It should be noted that the steps shown in FIGS. 17 through 21 are performed in the same way as that explained in the description of the first embodiment and therefore, explanation thereof is omitted for simplification.

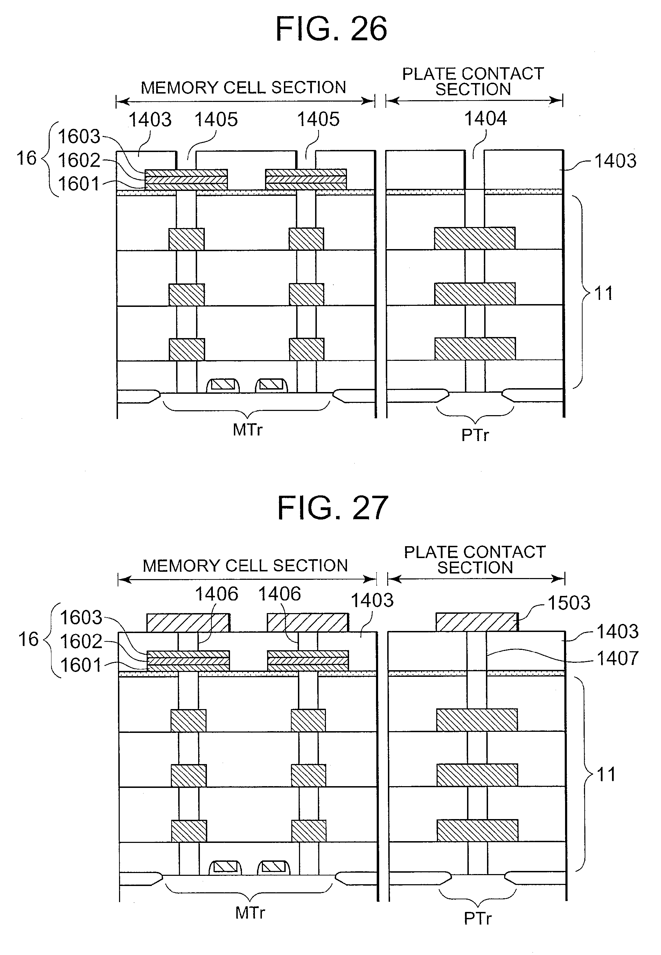

Following the step shown in FIG. 21, an interlayer insulation film 1403 is deposited over the entire structure and planarized (in this case, the interlayer insulation film is left on the upper electrode of the ferro-electric capacitor to have a thickness of about 400 nm) using CMP, as shown in FIG. 26. Then, contact holes 1404 and 1405 (in this case, both holes are formed to have a diameter of, for example, about 0.4 µm and the contact hole 1404 on the upper electrode is formed to have a depth of, for example, about 0.4 µm, and the contact hole 1405 on the contact stud is formed to have a depth of, for example, about 1.0 µm) are formed, using the etch stop layer 1301 as an etch stop, in the interlayer insulation film 1403 on the upper electrode 1603 of each of the ferro-electric capacitors 16 and on the contact stud 1110 in the plate contact section, respectively.

Thereafter, as shown in FIG. 27, a titanium nitride film as a barrier film is deposited over the entire structure to have a thickness of about 120 nm and a tungsten film is deposited over the entire structure to fill the contact holes 1404 and 1405, and then, desired portions of the tungsten film are removed using dry etching method or CMP to leave tungsten only within the contact holes 1404 and 1405, resulting in formation of a contact stud 1406 on each of the ferro-electric capacitors 16 and a contact stud 1407 in the plate contact section. Then, a lamination consisting of titanium nitride film, aluminum film and titanium nitride film is formed over the entire structure and patterned to form a plate line 1503. Similarly to the aforementioned embodiment, the embodiment has the interlayer insulation film planarized to facilitate formation of plate line. Furthermore, since formation of tungsten stud within the contact hole in the plate contact section is achieved by filling the contact hole with tungsten, even the contact hole having a large aspect ratio can easily be filled with tungsten. Accordingly, a contact hole employed in the embodiment can be formed to have a diameter smaller than that of the contact hole employed in the aforementioned embodiments, thereby simplifying design of contact hole and plate line provided in the plate contact section.

As described above, the present invention has been described with reference to the embodiments and the drawings, but detailed structures and methods employed in the present invention are not limited to those embodiments, and therefore, various modifications and improvements made to and in the above-described embodiments without departing from the spirit and scope of the objects of the present invention may be included in the present invention.

For example, the etch stop layer formed on the upperside surface of the tungsten stud and explained in the description of the embodiments may be a lamination consisting of silicon nitride film and silicon oxide film formed atop the silicon nitride film or a lamination consisting of silicon oxynitride film and silicon oxide film formed atop the silicon oxynitride film.

Moreover, upper and lower electrodes of ferro-electric capacitor may be comprised of a film containing novel metal such as ruthenium. When employing a ruthenium-based film as the upper and lower electrodes of ferro-electric capacitor, a lamination consisting of titanium film, titanium nitride film, titan film, ruthenium-based film is employed as a lower electrode and a film comprised primarily of a ruthenium-based film or a lamination consisting of ruthenium-based film and titanium nitride film is employed as an upper electrode.

Furthermore, the ferro-electric film employed in the invention may be a PBTiO.sub.3 film, SrBi.sub.2.Ta.sub.2.0.sub.9 film (SBT film), Pb.sub.(1-X).La.sub.X.Zr.sub.Y.Ti.sub.(1-Y).O.sub.3 film, Pb.sub. (1-X-Y) .La.sub.X.Ca.sub.Y.Zr.sub.Z.Ti.sub. (1-Z) .O.su b.3 film, or SrBi.sub.2. (Ta.sub.X.Nb.sub.(1-X)) .sub.2.0.sub.9 film.

Moreover, the plate line may be made from a copper film instead of using an aluminum-based metal film and formed with damascene technology.

Additionally, although the interconnect stack employed in the embodiment has been explained as a three-level conductive layer structure, the interconnect stack may be multi-level metal interconnects having undefined number of levels of interconnects.

As described'so far, since the multi-level interconnect structure employed in the embodiment is configured to form the contact stud overlying the etch stop layer in the multi-level interconnect structure in the plate contact section, the upper electrode of the ferro-electric capacitor and the contact stud in the plate contact section can securely be connected to each other through the plate line without causing failure of a connection between the plate line and the contact stud.

## Claims

1. A semiconductor memory device comprising:
a semiconductor substrate;
a memory cell section including a memory cell transistor formed on said semiconductor substrate;
a plate contact section including a plate transistor formed on said semiconductor substrate;
a first interlayer insulation film formed on said semiconductor substrate to cover said memory cell transistor and said plate transistor;
an etch stop layer formed on said first interlayer insulation film;
a ferro-electric capacitor including a lower electrode connected to said memory cell transistor, a ferro-electric film and an upper electrode, and formed on said etch stop layer in said memory cell section;
a second interlayer insulation film formed on an entire surface of said substrate to cover said ferro-electric capacitor;
a first contact hole corresponding to said ferro-electric capacitor and formed in said second interlayer insulation film in said memory cell section to expose said upper electrode of said ferro-electric capacitor;
a second contact hole formed in said second interlayer insulation film in said plate contact section; and
a plate line provided to connect said upper electrode and said plate transistor through said first contact hole and said second contact hole.

2. The semiconductor memory device according to claim 1, further comprising:
a first conductor formed to penetrate said first interlayer insulation film and said etch stop layer, and providing an electrical connection between said lower electrode of said ferro-electric capacitor and said memory cell transistor; and
a second conductor formed to penetrate said first interlayer insulation film and said etch stop layer, and providing an electrical connection between said plate transistor and said plate line formed in said second contact hole.

3. The semiconductor memory device according to claim 1, wherein said etch stop layer is made of a material which is etched at a rate slower than a rate at which said second interlayer insulation film is etched under etch condition used to form said first and second contact holes.

4. The semiconductor memory device according to claim 3, wherein said etch stop layer is made of a material which is etched at a rate slower than a rate at which said first interlayer insulation film is etched under etch conditions used to'form said first and second contact holes.

5. The semiconductor memory device according to claim 1, wherein said second interlayer insulation film is being planarized.

6. The semiconductor memory device according to claim 5, further comprising contact studs formed in said first contact hole and said second contact hole.

7. A semiconductor memory device comprising:
a semiconductor substrate;
a memory cell transistor having source and drain regions formed in said semiconductor substrate;
a first interlayer insulation film formed on said semiconductor substrate to cover said memory cell transistor;
an insulating layer formed on said first interlayer insulation film and made of such amaterial that resists an etchant etching an overlying layer directly covering said insulating layer;
a ferro-electric capacitor including a lower electrode formed on said insulating layer, a ferro-electric film formed on said lower electrode and an upper electrode formed on said ferro-electric film; and
a first contact stud selectively formed in said insulating layer and said first interlayer insulation film to provide a conductive path between one of said source and drain regions of said memory cell transistor and said lower electrode of said ferro-electric capacitor.

8. The semiconductor memory device according to claim 7, further comprising:
a plate transistor having source and drain regions formed in said semiconductor substrate;
a second interlayer insulation film formed on said insulating layer and provided as said overlying layer to cover said ferro-electric capacitor;
a first contact hole formed in said second interlayer insulation film to expose said upper electrode of said ferro-electric capacitor;
a second contact hole formed in said second interlayer insulation film and located above one of said source and drain regions of said plate transistor;
a second contact stud selectively formed in said insulating layer and said first interlayer insulation film to make electrical connection to one of said source and drain regions of said plate transistor; and
a plate line providing electrical connection between said upper electrode of said ferro-electric capacitor and said second contact stud.

9. The semiconductor memory device according to claim 7, wherein said overlying layer is a second uppermost level of insulating layer underlying an uppermost level of insulating layer.

10. A semiconductor memory device comprising a memory cell transistor having a ferro-electric capacitor, and a plate transistor connected to an upper electrode of said ferro-electric capacitor,
said plate transistor comprising:
source and drain regions selectively formed in a semiconductor substrate;
a first layer insulation film covering said source and drain regions;
an insulating layer formed on said first interlayer insulation film and made of a material different from that making up said first interlayer insulation film;
a contact stud selectively formed in said first interlayer insulation film and said insulting layer to make electrical connection to one of said source and drain regions of said plate transistor;
a second interlayer insulation film formed on said insulating layer; and
a contact hole formed in said second interlayer insulation film to provide electrical connection between said contact stud and said upper electrode of said ferro-electric capacitor.

11. The semiconductor memory device according to claim 10, further comprising a plate line electrically connecting said contact stud and said upper electrode of said ferro-electric capacitor wherein at least a part of said contact stud contacts said plate line through said contact hole and a portion, adjacent 'said at least a part of said contact stud, of said insulating layer contacts said plate line through said contact hole.

12. The semiconductor memory device according to claim 10, wherein said contact stud entirely contacts said plate line through said contact hole and portions, surrounding said contact stud, of said insulating layer contact said plate line through said contact hole.

13. The semiconductor memory device according to claim 10, wherein said second interlayer insulation film is a second uppermost level of insulating layer underlying an uppermost level of insulating layer.
